# EUROPÄISCHE PATENTSCHRIFT

(11) **EP 2 614 696 B1**
(45) Veröffentlichungstag und Bekanntmachung des Hinweises auf die Patenterteilung: **25.02.2015**
(21) Anmeldenummer: 11743792.1
(22) Anmeldetag: 12.07.2011
(51) Int. Cl.: H05K 9/00

(54) **STEUERGERÄT UND VERFAHREN ZUM ENTWERFEN EINER LEITERPLATTE EINES STEUERGERÄTS**
CONTROL UNIT AND METHOD FOR DESIGNING A PRINTED CIRCUIT BOARD OF A CONTROL UNIT
APPAREIL DE COMMANDE ET PROCÉDÉ DE CONCEPTION D'UNE CARTE DE CIRCUITS IMPRIMÉS D'UN APPAREIL DE COMMANDE

(30) Priorität: 10.09.2010 DE 102010040558
(43) Veröffentlichungstag der Anmeldung: 17.07.2013
(73) Patentinhaber: Robert Bosch GmbH, 70442 Stuttgart (DE)
(72) Erfinder: HUEBL, Jochen, 71732 Tamm (DE); KEICHER, Michael, 74172 Neckarsulm (DE)
(86) Internationale Anmeldenummer: PCT/EP2011/061821
(87) Internationale Veröffentlichungsnummer: WO 2012/031798

(56) Entgegenhaltungen:
- EP-A2- 0 998 176
- DE-A1- 3 108 546
- JP-A- 2007 214 061
- US-A1- 2006 087 821

## Beschreibung

### Stand der Technik

Die vorliegende Erfindung bezieht sich auf ein Steuergerät, insbesondere für ein Kraftfahrzeug, sowie auf ein Verfahren zum Entwerfen einer Leiterplatte eines Steuergeräts und ein Computerprogrammprodukt zur Durchführung des Verfahrens.

Moderne Kraftfahrzeuge enthalten eine Vielzahl elektronischer Steuergeräte, die an unterschiedlichen Stellen eingebaut werden, um steuernde oder regelnde Funktionen zu übernehmen. Ebenso werden Steuergeräte als eingebettete Systeme zur Steuerung und Regelung von Maschinen, Anlagen und sonstigen technischen Prozessen eingesetzt. Um einen sicheren Betrieb eines Steuergeräts an solchen Einbauorten zu ermöglichen, wo mit Entladungen statischer Elektrizität (ESD) und anderen potentiell störenden elektromagnetischen Effekten zu rechnen ist, muss eine ausreichende elektromagnetische Verträglichkeit (EMV) des Steuergeräts gewährleistet werden.

Industriestandards wie z.B. ISO 10605:2008 schreiben spezielle Testverfahren vor, mit denen die elektromagnetische Verträglichkeit eines Steuergeräts insbesondere im Hinblick auf elektrostatische Entladungen zu überprüfen ist. Hierbei wird das Steuergerät im Betrieb gezielt der Wirkung einer Luftentladung nahe seiner Gehäusewand ausgesetzt und überwacht, ob in der Elektronik des Steuergeräts Fehlfunktionen auftreten. Der in der Elektronik zum Ausfall führende Mechanismus besteht darin, dass hochohmige Schaltungsteile (z.B. Oszillatorschaltungen, Eingänge von Analog-Digital-Wandlern und nicht beschaltete Pins an ICs mit schwachen Pullup-Quellen, z.B. Testpins, Programmierpins, Sensoren) durch das hohe elektrostatische Feld in ihrem Spannungsniveau beeinflusst werden. Ist das Spannungsniveau einer derart gestörten Schaltung außerhalb ihres Funktionsbereiches kann es zum Fehlverhalten der Elektronik kommen.

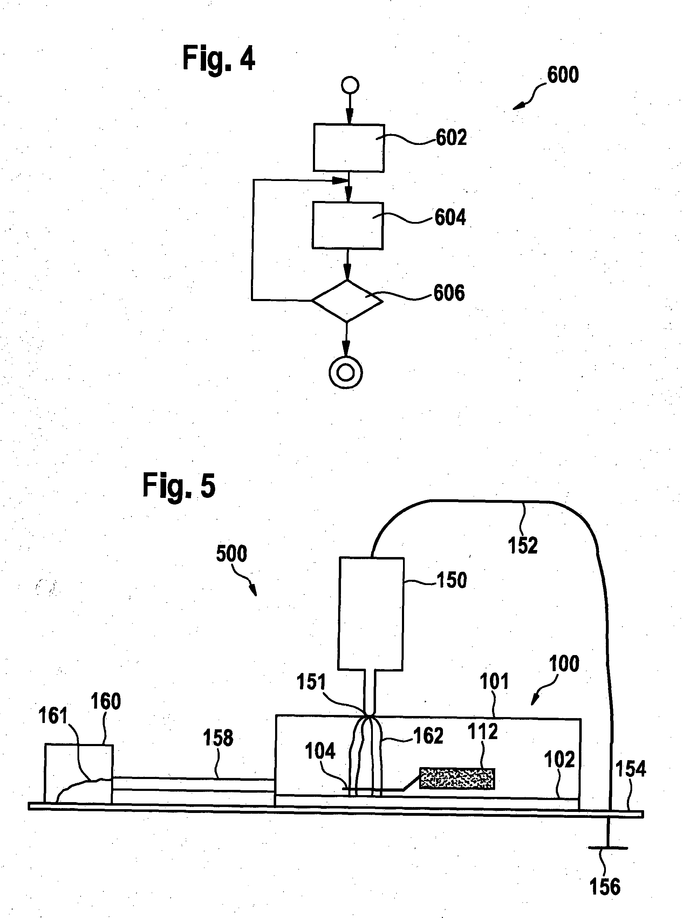

Figur 5 zeigt in einer Querschnittansicht ein herkömmliches Steuergerät 100 für ein Kraftfahrzeug, montiert auf einer Testeinrichtung 500, während der Durchführung eines hier vereinfacht dargestellten Tests auf elektromagnetische Störungen bei elektrostatischen Entladungen gemäß ISO 10605:2008. Das Steuergerät 100 weist ein Gehäuse 101 aus einem nichtleitenden Werkstoff und eine darin fixierte Leiterplatte 102 auf, die elektronische Bauteile trägt, von denen der Übersichtlichkeit halber nur eine Integrierte Schaltung 112 mit einem unbeschalteten Eingang 104 gezeigt ist.

Zur Durchführung des Tests wurde das Steuergerät 100 auf eine elektrisch mit dem Erdpotential 156 verbundene waagerechte Metallplatte 154 der Testeinrichtung 500 gesetzt. Über einen Kabelbaum 158 ist das Steuergerät elektrisch mit einer Lastnachbildung 160 verbunden, die eine im realen Betrieb vom Steuergerät 100 zu steuernde Last nachbildet und eine elektrische Anbindung 161 eines internen Massepotentials des Steuergeräts 100 an die geerdete Metallplatte 154 beinhaltet. Eine zur Testeinrichtung 500 gehörige ESD-Pistole 150 zur Erzeugung elektrostatischer Entladungen an einer Spitze 151 der Pistole 150 ist über eine flexible Leitung 152 ebenfalls mit geerdeten Metallplatte 154 verbunden. Während des Tests wird wie dargestellt im laufenden Betrieb des Steuergeräts 100 die ESD-Pistole mit ihrer Spitze 151 auf das Gehäuse 101 des Steuergeräts 100 gesetzt, mit einer hohen elektrischen Spannung gegenüber dem Erdpotential 156 eine Luftentladung aufgebracht und untersucht, ob ein Fehlverhalten des Steuergeräts 100 eintritt. Durch die Luftentladung bildet sich kurzzeitig ein elektrisches Feld 162 aus, das sich von der Spitze 151 der ESD-Pistole durch die Wand des Gehäuses 101 bis zur Leiterplatte 102 nahe des unbeschalteten Eingangs 104 der Integrierten Schaltung 112 erstreckt. Das elektrische Feld 162 beeinflusst das Spannungsniveau am unbeschalteten Eingang 104, sodass eine Betriebsstörung des Steuergeräts 100 auftritt.

Eine Herangehensweise, die Konstruktion eines Steuergeräts nachzubessern, wenn mit einem derartigen Testverfahren Ausfälle infolge elektrostatischer Entladungen erkannt werden, besteht darin, den Abstand zwischen der Gehäusewand und dem betroffenen Schaltungsteil zu vergrößern. Dies ist jedoch aufwendig, da Form- und andere Produktionswerkzeuge angepasst werden müssen, und führt zu einem nachteilig erhöhten Gehäusevolumen.

Ein weiterer Ansatz besteht darin, die Volumenleitfähigkeit des Gehäusematerials durch Einbringen elektrisch leitender Materialien zu erhöhen, was jedoch eine Neukonstruktion des Gehäuses mit entsprechend erhöhten Kosten erfordert. Hohen Aufwand erfordert auch, eine leitfähige Schicht am Gehäuseinneren anzubringen, da zusätzliche Arbeitsschritte für das Anbringen und Kontaktieren der Schicht notwendig werden. Noch aufwendiger ist, leitfähige Schirmflächen oder spezielle Kapselungen um die betroffenen Schaltungsteile in das Steuergerät einzubauen.

Es ist daher wünschenswert, die Verträglichkeit eines Steuergeräts gegenüber elektrostatischen Entladungen mit geringem Aufwand insbesondere konstruktiver Veränderungen zu verbessern.

### Offenbarung der Erfindung

Demgemäß vorgesehen ist ein Steuergerät, insbesondere für ein Kraftfahrzeug, mit einer Leiterplatte, einem auf der Leiterplatte angeordneten Hochimpedanz-Schaltungsteil, der eine Impedanz von 1 kΩ oder höher gegenüber einer Masse des Steuergeräts aufweist, und mindestens einem elektrisch mit der Masse verbundenen leitfähigen Schutzelement, das neben dem Hochimpedanz-Schaltungsteil auf der Leiterplatte angeordnet ist und innerhalb eines Schutzabstands vom Hochimpedanz-Schaltungsteil eine Höhe aufweist, die mindestens gleich dem Schutzabstand ist. Die räumlichen Begriffe wie "auf", "neben" und "Höhe" beziehen sich auf diejenige Oberfläche der Leiterplatte, die das Hochimpedanz-Schaltungsteil trägt.

Unter weiteren Gesichtspunkten schafft die Erfindung ein Verfahren zum Entwerfen einer Leiterplatte eines Steuergeräts und ein Computerprogrammprodukt zur Durchführung des Verfahrens, gemäß dem zunächst auf der Leiterplatte eine Position eines Hochimpedanz-Schaltungsteils mit einer Impedanz von 1 kΩ oder höher gegenüber einer Masse des Steuergeräts festgelegt wird. In einem weiteren Verfahrensschritt wird eine Position, neben dem Hochimpedanz-Schaltungsteil auf der Leiterplatte, mindestens eines elektrisch mit der Masse verbundenen leitfähigen Schutzelements derart festgelegt, dass das Schutzelement innerhalb eines Schutzabstands vom Hochimpedanz-Schaltungsteil eine Höhe aufweist, die mindestens gleich dem Schutzabstand ist.

### Vorteile der Erfindung

Die Erfindung beruht auf der Idee, ein mit Masse verbundenes, leitfähiges Schutzelement hinreichend nahe neben dem Hochimpedanz-Schaltungsteil auf der Leiterplatte anzuordnen, sodass der Verlauf eines durch eine elektrostatische Entladung außerhalb des Steuergeräts hervorgerufen elektrischen Feldes zum Schutzelement hin abgelenkt wird. Die Höhe des Schutzelements, die gleich groß oder größer ist als der Abstand zwischen dem Schutzelement und dem Hochimpedanz-Schaltungsteil, hat zur Folge, dass im Falle einer elektrostatischen Entladung, die außerhalb des Steuergeräts über der Position des Hochimpedanz-Schaltungsteils auf der Leiterplatte auftritt, die Weglänge vom Ort der Entladung zum Schutzelement in etwa gleich oder kleiner ist als die Weglänge vom Ort der Entladung zum Hochimpedanz-Schaltungsteil. Da das Schutzelement mit Masse verbunden ist, während das Hochimpedanz-Schaltungsteil durch mindestens 1 kΩ von Masse getrennt ist, baut sich ein elektrisches Feld auf, dessen Feldlinien zwischen dem Ort der Entladung und dem oberen Ende des Schutzelements verlaufen, während der Raum um das Hochimpedanz-Schaltungsteil wesentlich frei von Feldlinien bleibt.

Erfindungsgemäß ist das Schutzelement, anders als z.B. herkömmliche Schirmflächen und Kapselungen, lediglich neben dem Hochimpedanz-Schaltungsteil auf der Leiterplatte angeordnet, sodass der verbesserte Schutz des Hochimpedanz-Schaltungsteils ohne großen Aufwand zu erreichen ist. Da es ausreicht, wenn das Schutzelement lediglich die angegebene Höhe aufweist, kann das Schutzelement mit geringen Breitenabmessungen ausgebildet werden, sodass es einfach und kostengünstig herstellbar ist, nur wenig Leiterplattenfläche belegt und in bestehende Leiterplatten-Layouts ohne aufwendige Änderungen nachträglich integriert werden kann. Weitergehende Änderungen z.B. an einem Gehäuse des Steuergeräts sind nicht erforderlich.

Gemäß einer bevorzugten Weiterbildung weist das Steuergerät ein Gehäuse mit einem wesentlich nichtleitenden Werkstoff auf, z.B. mit einer Leitfähigkeit unterhalb von 1 mS. Derartige Materialien wie z.B. Kunststoffe sind in großer Vielfalt bekannt, sodass besonders kostengünstige und/oder leichtgewichtige Materialien einsetzbar sind.

Gemäß einer bevorzugten Weiterbildung umfasst der Hochimpedanz-Schaltungsteil einen Oszillator, einen Sensor, einen Eingang eines Analog-Digital-Wandlers oder/und einen unbeschalteten Anschluss einer Integrierten Schaltung wie z.B. einen Programmier- oder Testeingang. Derartige Schaltungsteile sind typischerweise besonders empfindlich gegenüber elektrostatischen Entladungen, sodass eine maximale Schutzwirkung erzielbar ist.

Gemäß einer bevorzugten Weiterbildung liegt eine Grundfläche des Hochimpedanz-Schaltungsteils auf der Leiterplatte wesentlich innerhalb des Schutzabstandes um einen Abschnitt der Leiterplatte, über dem das mindestens eine Schutzelement die Höhe aufweist. Auf diese Weise fällt auch bei großflächig ausgebildeten Hochimpedanz-Schaltungsteilen das gesamte Hochimpedanz-Schaltungsteil zuverlässig in den durch das Schutzelement geschützten Bereich, da für jeden Punkt der Grundfläche einen Punkt des mindestens einen Schutzelements gibt, der eine größere Höhe als den Abstand zwischen beiden Punkten aufweist.

Gemäß einer bevorzugten Weiterbildung liegt das Hochimpedanz-Schaltungsteil wesentlich innerhalb eines Schutzraums um das mindestens eine Schutzelement, der durch Überlagerung einer Vielzahl gerader Kreiskegel bildbar ist, die jeweils einen Öffnungswinkel von 90°, eine Kegelspitze am mindestens einen Schutzelement und eine Basiskreisebene auf der Leiterplatte aufweisen. Auf diese Weise fällt insbesondere bei Hochimpedanz-Schaltungsteilen mit erheblicher Höhe über der Leiterplatte das gesamte Hochimpedanz-Schaltungsteil zuverlässig in den durch das Schutzelement geschützten Bereich, da es für jeden Punkt an einer Oberfläche des Hochimpedanz-Schaltungsteils einen Punkt des mindestens einen Schutzelements gibt, der eine größere Höhe als den Abstand zwischen beiden Punkten aufweist.

Gemäß einer bevorzugten Weiterbildung ist das mindestens eine Schutzelement wesentlich in senkrecht von der Leiterplatte aufragender Stab- oder Plattenform ausgebildet. Dies erfordert besonders geringen Flächen- und Materialaufwand.

Gemäß einer bevorzugten Weiterbildung weist das mindestens eine Schutzelement einen in einer Öffnung der Leiterplatte gehaltenen Einpressstift auf. Derartige Stifte, auch als Pressfit-Pins bezeichnet, sind kostengünstig als Massenfabrikate in Standardabmessungen erhältlich und besonders einfach durch Einpressen in eine Öffnung der Leiterplatte zu fixieren, wobei ohne zusätzlichen Schritt bei geeignet vorgesehener Leiterbahn gleichzeitig der elektrische Kontakt nach Masse herstellbar ist. Vorzugsweise dient zudem der Einpressstift dazu, die Leiterplatte im Steuergerät zu fixieren, beispielsweise indem der Einpressstift im Eingriff mit einem Gehäusedeckel als Niederhalter für die Leiterplatte dient. Die Doppelfunktion des Einpressstifts führt zu einer weiteren Verringerung des konstruktiven Aufwands, da z.B. ein an anderer Stelle auf der Leiterplatte vorgesehener Einpressstift entfallen kann, sodass die erfinderische Maßnahme weder zusätzliche Bauteile noch Leiterplattenfläche erfordert.

Gemäß einer bevorzugten Weiterbildung ist das mindestens eine Schutzelement als ein Schaltungsbauteil ausgebildet, das mindestens einen mit der Masse verbundenen Anschluss aufweist. Beispielsweise kann das Schutzelement als ein Kondensator, ein Transistor oder eine Diode ausgebildet sein. Dies ermöglicht z.B., ein ohnehin in der Elektronik des Steuergeräts benötigtes Schaltungsbauteil zusätzlich als Schutzelement zu verwenden, sodass weder ein zusätzliches Schutzelement noch zusätzliche Leiterplattenfläche benötigt werden.

### Kurze Beschreibung der Zeichnungen

Die vorliegende Erfindung wird nachfolgend anhand bevorzugter Ausführungsformen und beigefügter Figuren erläutert. In den Figuren zeigten:
- Fig. 1: eine Querschnittansicht eines Steuergeräts für ein Kraftfahrzeug gemäß einer Ausführungsform der Erfindung, beim Testen des Steuergeräts auf elektromagnetische Verträglichkeit;
- Fig. 2: eine ausschnitthafte Draufsicht auf eine Leiterplatte eines Steuergeräts gemäß einer weiteren Ausführungsform;
- Fig. 3: eine ausschnitthafte Querschnittansicht der Leiterplatte aus Fig. 2 entlang der Linie I - I';
- Fig. 4: ein Ablaufdiagramm eines Verfahrens zum Entwerfen einer Leiterplatte eines Steuergeräts gemäß einer Ausführungsform; und
- Fig. 5: eine Querschnittansicht eines herkömmlichen Steuergeräts für ein Kraftfahrzeug beim Testen des Steuergeräts auf elektromagnetische Verträglichkeit.

In den Figuren bezeichnen dieselben Bezugszeichen gleiche oder funktionsgleiche Komponenten, soweit nichts Gegenteiliges angegeben ist.

### Ausführungsformen der Erfindung

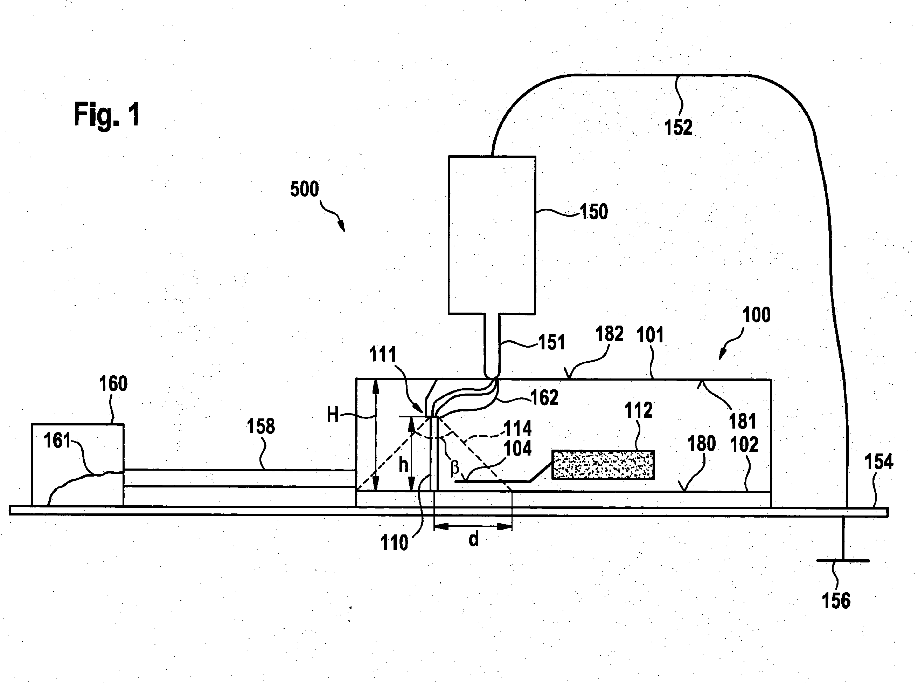

Figur 1 zeigt in einer Querschnittansicht eines Steuergeräts 100 für ein Kraftfahrzeug, montiert auf einer Testeinrichtung 500, während der Durchführung eines hier vereinfacht dargestellten Tests auf elektromagnetische Störungen bei elektrostatischen Entladungen gemäß ISO 10605:2008. Der Aufbau der Testeinrichtung, 500 ist identisch mit der in Fig. 5 gezeigten.

Das Steuergerät 100 stimmt in seinem grundlegenden Aufbau mit dem herkömmlichen Steuergerät aus Fig. 5 überein, weist jedoch zusätzlich ein leitfähiges, stabförmiges Schutzelement 110 auf, das neben dem unbeschalteten Eingang 104 senkrecht auf der Leiterplatte 102 befestigt ist und bis zu einer Höhe h über die Oberfläche 180 der Leiterplatte 102 aufragt. Die Höhe h des Schutzelements beträgt etwa 2/3 der Höhe H einer Deckeninnenseite 181 des Gehäuses 101, gemessen jeweils ab der Oberseite 180 der Leiterplatte. Elektrisch ist das Schutzelement 110 mit der Masse des Steuergeräts 100 verbunden, z.B. über eine geeignet geführte, hier nicht gezeigte Leiterbahn an der Unter- oder/und Oberseite 180 der Leiterplatte 102.

Während des in Fig. 1 dargestellten Tests, der auf die gleiche Weise wie in Fig. 5 erfolgt, wird im laufenden Betrieb des Steuergeräts 100 die ESD-Pistole mit ihrer Spitze 151 auf das Gehäuse 101 des Steuergeräts 100 gesetzt, mit einer hohen elektrischen Spannung gegenüber dem Erdpotential 156 eine Luftentladung aufgebracht und untersucht, ob ein Fehlverhalten des Steuergeräts 100 eintritt. Durch die Luftentladung bildet sich kurzzeitig ein elektrisches Feld 162 aus, dessen Feldlinien sich ausgehend von der Spitze 151 der ESD-Pistole durch die Wand des Gehäuses 101 und weiter seitlich bis zum höchsten Punkt 111 des Schutzelements 110 erstrecken. Obwohl die Spitze 151 der ESD-Pistole 150 wie in Fig. 5 direkt über dem unbeschalteten Eingang 104 der Integrierten Schaltung 112 auf das Gehäuse 101 gesetzt wurde, bleibt damit der Bereich um den unbeschalteten Eingang 104 wesentlich feldfrei, sodass das Spannungsniveau des unbeschalteten Eingangs 104 nicht beeinflusst und ein ungestörter Betrieb des Steuergeräts 100 ermöglicht wird.

Um das Schutzelement 110 ist in Fig. 1 ein Schutzbereich 114 gestrichelt markiert, auf den sich angenähert die Schutzwirkung des Schutzelements 110, elektrische Felder von hochohmigen Schaltungsteilen fernzuhalten, erstreckt. Der Schutzbereich 110 besitzt die Form eines sich nach unten hin aufweitenden Kreiskegels mit Öffnungswinkel β = 90°, dessen Kegelspitze mit dem höchsten Punkt 111 des Schutzelements 110 und dessen Basiskreisebene mit der Oberseite 180 der Leiterplatte 102 zusammenfällt. Die Kegelachse des Kreiskegels fällt mit der Zentralachse des stabförmigen Schutzelements 110 zusammen, und der Radius d des Basiskreises auf der Leiterplatte 102 ist gleich der Höhe h des Schutzelements 110. Der unbeschaltete Eingang 104 liegt mit einem wesentlichen Abschnitt innerhalb des Schutzbereichs 114. Betrachtet man die Projektionen des unbeschalteten Eingangs 104 und des höchsten Punkts 111 des Schutzelements 110 auf die Leiterplatte 102, so beträgt der Abstand zwischen beiden weniger als die Höhe h.

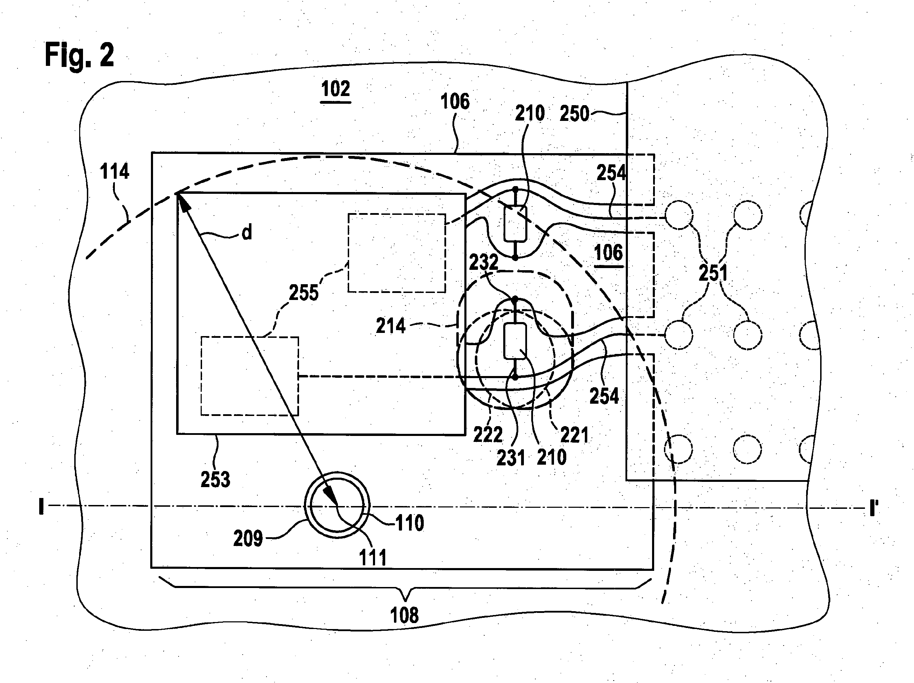

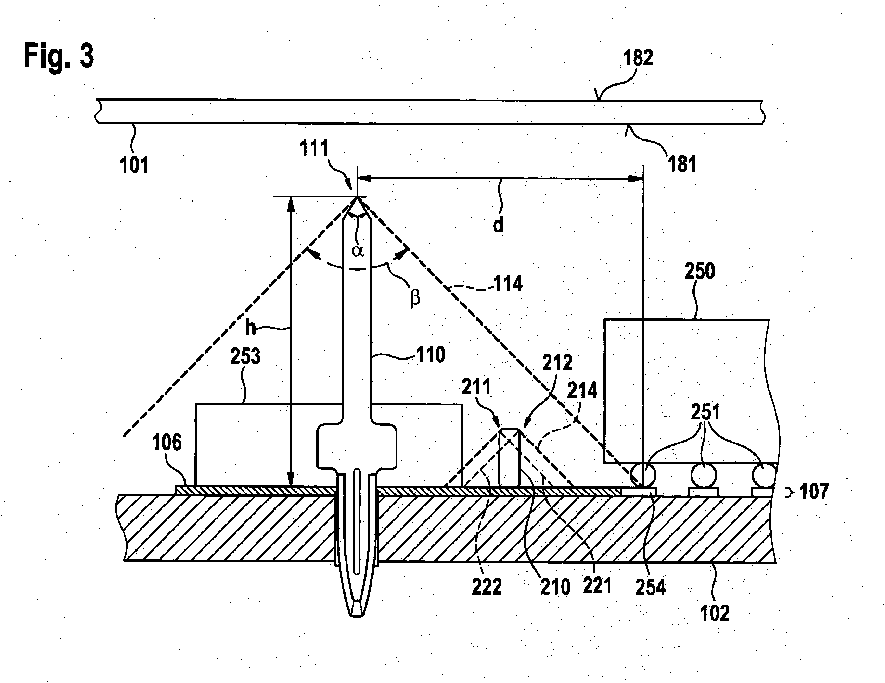

Figur 2 und 3 zeigen einen Ausschnitt aus einer Leiterplatte 102 eines Steuergeräts für ein Kraftfahrzeug gemäß einer weiteren Ausführungsform. Auf der Leiterplatte 102 befindet sich eine Metallisierungsschicht 107, in welcher durch Ätzen oder ein anderes geeignetes Verfahren unterschiedliche Leiterbahnen 254, 106 gebildet sind.

Ein Quarzoszillator 253 ist montiert innerhalb eines rechteckigen Schirmbereichs 108 der Leiterplatte 102, in welchem diese überwiegend von einer aus der Metallisierungsschicht 107 gebildeten Masse-Leiterbahn 106 bedeckt ist. Durch den Schirmbereich 108 führen weitere Leiterbahnen 254, die von der Masse-Leiterbahn 106 isoliert sind, von Anschlusskontakten 255 an der Unterseite des Quarzoszillators 253 aus dem Schirmbereich 108 hinaus, wo sie durch Lotkugeln 251 einer Lotkugelmatrix kontaktiert werden, mit welcher ein Mikrocontroller 250 auf der Leiterplatte 102 montiert ist. Zwischen dem Quarzoszillator 253 und dem Mikrocontroller 250 sind zwei Kondensatoren 210 auf der Leiterplatte montiert, die jeweils einen mit der Masse-Leiterbahn 106 verbundenen Anschluss 232 und einen weiteren Anschluss 231 aufweisen, der jeweils mit einer der den Mikrocontroller 250 mit dem Quarzoszillator 253 verbindenden, von Masse 106 isolierten Leiterbahnen 254 verbunden ist.

Neben dem Quarzoszillator 253, der ein hochohmiges Schaltungsteil, d.h. ein Schaltungsteil mit einer Impedanz von 1 kΩ oder mehr gegenüber Masse 106 darstellt, ist innerhalb des Schirmbereichs 108 eine Bohrung 209 durch die Leiterplatte gebildet. Eingepresst in die Bohrung 209 ist ein metallischer Einpressstift 110 als Schutzelement für den Quarzoszillator 253, um diesen vor Einwirkungen elektrischer Felder zu schützen, die von elektrostatischen Entladungen außerhalb des Steuergeräts ausgehen. Der Einpressstift 110 ist elektrisch mit Masse verbunden, indem er die das Einpressloch 209 umgebende Masse-Leiterbahn 106 und/oder eine ggf. zusätzlich in der Lochleibung ausgebildete, hier nicht gezeigte Lochleibungs-Metallisierungsschicht kontaktiert, die mit der Masse-Leiterbahn 106 elektrisch verbunden ist. Der Einpressstift 110 weist eine Höhe h von beispielhaft 3,5 mm und an seinem oberen Ende eine konische Spitze 111 mit einem Öffnungswinkel α von ca. 30° bis 60° auf.

Um den Einpressstift 110 ist gestrichelt ein kreiskegelförmiger Schutzbereich 114 markiert, wie bereits mit Bezug auf Fig. 1 erläutert. Der Quarzoszillator 253 liegt vollständig innerhalb dieses Schutzbereichs 114. Insbesondere ist in Fig. 2 zu erkennen, dass die Grundfläche des Quarzoszillators 253 auf der Leiterplatte 102 innerhalb des Basiskreises des kreiskegelförmigen Schutzbereichs 114 liegt. Damit wird im Falle elektrostatischer Entladungen an der Außenseite 182 einer nichtleitenden Gehäusewand 101, die über der Leiterplatte 102 verläuft, der Quarzoszillator 253 vor Fehlfunktionen durch elektrische Felder geschützt.

Da die beiden Kondensatoren 210 jeweils einen mit Masse 106 verbundenen Anschluss 232 aufweisen, wirken sie ebenfalls als Schutzelemente. Der durch ein unregelmäßig geformtes Schutzelement wie einen der Kondensatoren 210 gebildete Schutzbereich 214 lässt sich erhalten, indem man für jeden Punkt an der Oberfläche des betreffenden Kondensators 210 einen nach unten geöffneten Kreiskegel konstruiert, der im betreffenden Punkt seine Kegefspitze hat. Durch Überlappen der Vielzahl der so erhaltenen Kreiskegel 221, 222 - hier stellvertretend für zwei obere Ecken 211, 212 der angenäherten Quaderform des Kondensators 210 gezeigt - ergibt sich der Schutzbereich 214 des unregelmäßig geformten Schutzelements, in diesem Fall des Kondensators 210. Da dieser Bereich jedoch im in Fig. 2 und 3 gezeigten Beispiel anhand eines der Kondensatoren 210 vollständig innerhalb des Schutzbereichs 114 des Einpressstifts 110 liegt, ist der insgesamt durch den Einpressstift 110 und den betrachteten Kondensator 210 geschützte gesamte Schutzbereich identisch mit dem Schutzbereich 114 des Einpressstifts 110 allein.

Figur 4 zeigt ein Ablaufdiagramm eines Verfahrens 600 zum Entwerfen einer Leiterplatte eines Steuergeräts. In Schritt 602 wird zunächst auf der Leiterplatte eine Position eines Hochimpedanz-Schaltungsteils mit einer Impedanz von 1 kΩ oder höher gegenüber einer Masse des Steuergeräts festgelegt. In einem weiteren Verfahrensschritt 604 wird eine Position, neben dem Hochimpedanz-Schaltungsteil auf der Leiterplatte, eines elektrisch mit der Masse verbundenen leitfähigen Schutzelements einer gegebenen Höhe h derart festgelegt, dass ein möglichst großer Abschnitt des Hochimpedanz-Schaltungsteils innerhalb eines kreisförmigen Schutzbereichs um das Schutzelement liegt, dessen Radius gleich der Höhe des Schutzelements ist.

In Entscheidungsschritt 606 wird überprüft, ob der Schutzbereich bereits das gesamte Hochimpedanz-Schaltungsteil abdeckt. Ist dies nicht der Fall, springt das Verfahren zurück zu Schritt 604, wo nun die Position eines weiteren, gleichartigen Schutzelements derart festgelegt wird, dass ein möglichst großer Abschnitt des Hochimpedanz-Schaltungsteils innerhalb Gesamtschutzbereichs liegt, der durch die Überlappung der einzelnen kreisförmigen Schutzbereiche um das einzelnen Schutzelemente gebildet wird. In Entscheidungsschritt 606 wird dann überprüft, ob der Gesamtschutzbereich bereits das gesamte Hochimpedanz-Schaltungsteil abdeckt. Ist dies nicht der Fall, springt das Verfahren zurück zu Schritt 604.

Wird in Entscheidungsschritt 606 festgestellt dass der Schutzbereich der bisher positionierten Schutzelemente das Hochimpedanz-Schaltungsteil vollständig abdeckt, endet das Verfahren.

## Patentansprüche

1. Steuergerät (100), insbesondere für ein Kraftfahrzeug, mit:
- einer Leiterplatte (102);
- einem auf der Leiterplatte (102) angeordneten Hochimpedanz-Schaltungsteil (104), welcher eine Impedanz von 1 kΩ oder höher gegenüber einer Masse (106) des Steuergeräts (100) aufweist; und
- mindestens einem elektrisch mit der Masse (106) verbundenen leitfähigen Schutzelement (110, 210), welches einen in einer Öffnung der Leiterplatte (102) gehaltenen Einpressstift (110) aufweist, wobei der Einpressstift (110) die Leiterplatte (102) im Steuergerät (100) fixiert, neben dem Hochimpedanz-Schaltungsteil (104) auf der Leiterplatte (102) angeordnet ist und innerhalb eines Schutzabstands (d) vom Hochimpedanz-Schaltungsteil (104) eine Höhe (h) aufweist, die mindestens gleich dem Schutzabstand (d) ist.

2. Steuergerät (100) nach Anspruch 1 mit einem Gehäuse (101), das einen wesentlich nichtleitenden Werkstoff aufweist.

3. Steuergerät (100) nach Anspruch 1 oder 2, wobei der Hochimpedanz-Schaltungsteil (104) einen Oszillator (253), einen Sensor, einen Eingang eines Analog-Digital-Wandlers oder/und einen unbeschalteten Anschluss (104) einer Integrierten Schaltung (112) umfasst.

4. Steuergerät (100) nach einem der vorhergehenden Ansprüche, wobei eine Grundfläche des Hochimpedanz-Schaltungsteils (104) auf der Leiterplatte (102) wesentlich innerhalb des Schutzabstandes (d) um einen Abschnitt der Leiterplatte (102) liegt, über welchem das mindestens eine Schutzelement (110, 210) die Höhe (h) aufweist.

5. Steuergerät (100) nach Anspruch 4, wobei das Hochimpedanz-Schaltungsteil (104) wesentlich innerhalb eines Schutzraums (114) um das mindestens eine Schutzelement (110, 210) liegt, welcher durch Überlagerung einer Vielzahl gerader Kreiskegel (114, 221, 222) bildbar ist, die jeweils einen Öffnungswinkel (β) von 90°, eine Kegelspitze (211, 212) am mindestens einen Schutzelement (110, 210) und eine Basiskreisebene auf der Leiterplatte (102) aufweisen.

6. Steuergerät (100) nach einem der vorhergehenden Ansprüche, wobei das mindestens eine Schutzelement (110, 210) wesentlich in senkrecht von der Leiterplatte (102) aufragender Stab- oder Plattenform ausgebildet ist.

7. Steuergerät (100) nach einem der vorhergehenden Ansprüche, wobei das mindestens eine Schutzelement (110, 210) ein Schaltungsbauteil (210) aufweist, welches an mindestens einem Anschluss (232) mit der Masse (106) verbunden ist.

8. Verfahren (600) zum Entwerfen einer Leiterplatte (102) eines Steuergeräts (100), insbesondere für ein Kraftfahrzeug, mit folgenden Schritten:
Festlegen (602) einer Position eines Hochimpedanz-Schaltungsteils (104), welcher eine Impedanz von 1 kΩ oder höher gegenüber einer Masse (106) des Steuergeräts (100) aufweist, auf der Leiterplatte (102);
- Festlegen (604) einer Position, neben dem Hochimpedanz-Schaltungsteil (104) auf der Leiterplatte (102), mindestens eines elektrisch mit der Masse (106) verbundenen leitfähigen Schutzelements (110, 210), welches einen in einer Öffnung der Leiterplatte (102) gehaltenen Einpressstift (110) aufweist, der die Leiterplatte (102) im Steuergerät (100) fixiert, derart, dass das mindestens eine Schutzelement (110, 210) innerhalb eines Schutzabstands (d) vom Hochimpedanz-Schaltungsteil (104) eine Höhe (h) aufweist, die mindestens gleich dem Schutzäbstand (d) ist.

9. Computerprogrammprodukt mit Programmanweisungen, welche auf einem maschinenlesbaren Trägen gespeichert sind, zur Durchführung des Verfahrens (600) nach Anspruch 8.

## Claims

1. Controller (100), in particular for a motor vehicle, having:
- a printed circuit board (102);
- a high-impedance circuit section (104) which is arranged on the printed circuit board (102) and which has an impedance of 1 kΩ or higher with respect to an earth (106) of the controller (100); and
- at least one protection element (110, 210) which is electrically conductively connected to the earth (106), which has a press-in pin (110) that is held in an opening in the printed circuit board (102), wherein the press-in pin (110) fixes the printed circuit board (102) in the controller (100), which is arranged next to the high-impedance circuit section (104) on the printed circuit board (102) and which, within a protection distance (d) from the high-impedance circuit section (104), has a height (h) which is at least equal to the protection distance (d).

2. Controller (100) according to Claim 1, having a housing (101) which has a substantially non-conductive material.

3. Controller (100) according to Claim 1 or 2, wherein the high-impedance circuit section (104) comprises an oscillator (253), a sensor, an input to an analogue/digital converter or/and an open-circuit connection (104) of an integrated circuit (112).

4. Controller (100) according to one of the preceding claims, wherein a base area of the high-impedance circuit section (104) on the printed circuit board (102) is situated substantially within the protection distance (d) around a portion of the printed circuit board (102) above which the at least one protection element (110, 210) has the height (h).

5. Controller (100) according to Claim 4, wherein the high-impedance circuit section (104) is situated substantially within a protection space (114) around the at least one protection element (110, 210) which can be formed by superimposition of a large number of upright circular cones (114, 221, 222) which each have an opening angle (β) of 90°, a cone tip (211, 212) on the at least one protection element (110, 210) and a base circular plane on the printed circuit board (102).

6. Controller (100) according to one of the preceding claims, wherein the at least one protection element (110, 210) is formed substantially in a rod or plate shape which projects perpendicularly from the printed circuit board (102).

7. Controller (100) according to one of the preceding claims, wherein the at least one protection element (110, 210) has a circuit component (210) which is connected to the earth (106) at at least one connection (232).

8. Method (600) for designing a printed circuit board (102) of a controller (100), in particular for a motor vehicle, comprising the following steps:
- defining (602) a position of a high-impedance circuit section (104), which has an impedance of 1 kΩ or higher with respect to an earth (106) of the controller (100), on the printed circuit board (102);
- defining (604) a position, next to the high-impedance circuit section (104) on the printed circuit board (102), of at least one protection element (110, 210), which is electrically conductively connected to the earth (106) and which has a press-in pin (110) that is held in an opening in the printed circuit board (102) and fixes the printed circuit board (102) in the controller (100), in such a way that the at least one protection element (110, 210), within a protection distance (d) from the high-impedance circuit section (104), has a height (h) which is at least equal to the protection distance (d).

9. Computer program product having program instructions, which are stored in a machine-readable carrier, for carrying out the method (600) according to Claim 8.

## Revendications

1. Appareil de commande (100), en particulier pour un véhicule automobile, avec :
- une carte de circuits imprimés (102) ;
- une partie de circuit à haute impédance (104) disposée sur la carte de circuits imprimés (102), laquelle présente une impédance de 1 kΩ ou plus par rapport à une masse (106) de l'appareil de commande (100) ; et
- au moins un élément de protection conducteur (110, 210) relié électriquement à la masse (106), lequel présente une broche d'insertion (110) maintenue dans une ouverture de la carte de circuits imprimés (102), la broche d'insertion (110) fixant la carte de circuits imprimés (102) dans l'appareil de commande (100), est disposé à côté de la partie de circuit à haute impédance (104) sur la carte de circuits imprimés (102), et présente une hauteur (h) dans les limites d'une distance de sécurité (d) par rapport à la partie de circuit à haute impédance (104), laquelle est au minimum égale à la distance de sécurité (d).

2. Appareil de commande (100) selon la revendication 1 avec un boîtier (101) qui présente un matériau sensiblement non conducteur.

3. Appareil de commande (100) selon la revendication 1 ou 2, dans lequel la partie de circuit à haute impédance (104) comprend un oscillateur (253), un capteur, une entrée d'un convertisseur analogique/numérique et/ou un raccord (104) non câblé d'un circuit intégré (112).

4. Appareil de commande (100) selon l'une des revendications précédentes, dans lequel une surface de base de la partie de circuit à haute impédance (104) sur la carte de circuits imprimés (102) se situe sensiblement dans les limites de la distance de sécurité (d) autour d'un segment de la carte de circuits imprimés (102) sur lequel l'au moins un élément de protection (110, 210) présente la hauteur (h).

5. Appareil de commande (100) selon la revendication 4, dans lequel la partie de circuit à haute impédance (104) se situe sensiblement à l'intérieur d'un espace de protection (114) autour de l'au moins un élément de protection (110, 210), lequel espace de protection peut être formé par superposition d'une pluralité de cônes de révolution droits (114, 221, 222) qui présentent respectivement un angle d'ouverture (β) de 90°, une pointe de cône (211, 212) sur l'au moins un élément de protection (110, 210) et un plan de cercle de base sur la carte de circuits imprimés (102).

6. Appareil de commande (100) selon l'une des revendications précédentes, dans lequel l'au moins un élément de protection (110, 210) est réalisé sensiblement en forme de tige ou de plaque s'érigeant perpendiculairement à partir de la carte de circuits imprimés (102).

7. Appareil de commande (100) selon l'une des revendications précédentes, dans lequel l'au moins un élément de protection (110, 210) présente un composant de circuit (210), lequel est relié à la masse (106) au niveau d'au moins un raccord (232).

8. Procédé (600) pour la conception d'une carte de circuits imprimés (102) d'un appareil de commande (100), en particulier pour un véhicule automobile, avec les étapes suivantes :
- détermination (602) d'une position d'une partie de circuit à haute impédance (104) qui présente une impédance de 1 kΩ ou plus par rapport à une masse (106) de l'appareil de commande (100) sur la carte de circuits imprimés (102) ;
- détermination (604) d'une position, à côté de la partie de circuit à haute impédance (104) sur la carte de circuits imprimés (102), d'au moins un élément de protection conducteur (110, 210) relié électriquement à la masse (106), lequel présente une broche d'insertion (110) maintenue dans une ouverture de la carte de circuits imprimés (102), laquelle fixe la carte de circuits imprimés (102) dans l'appareil de commande (100), de manière à ce que l'au moins un élément de protection (110, 210) présente une hauteur (h) dans les limites d'une distance de sécurité (d) par rapport à la partie de circuit à haute impédance (104), laquelle hauteur est au minimum égale à la distance de sécurité (d).

9. Produit de programme informatique avec des instructions de programme, lesquelles sont enregistrées sur un support lisible par machine, pour la mise en oeuvre du procédé (600) selon la revendication 8.
